# EUROPEAN PATENT SPECIFICATION

(11) **EP 0 376 685 B1**
(45) Date of publication and mention of the grant of the patent: **18.10.1995**
(21) Application number: 89313598.8
(22) Date of filing: 27.12.1989
(51) Int. Cl.: H01L 27/108

(54) **Semiconductor memory having an increased cell capacitance in a restricted cell area**
Halbleiterspeicher mit erhöhter Zellkapazität auf beschränkter Zellfläche
Mémoire à semi-conducteurs ayant une capacité de cellule augmentée dans une aire de cellule restreinte

(30) Priority: 27.12.1988 JP 331716/88
(43) Date of publication of application: 04.07.1990
(73) Proprietor: NEC CORPORATION, Tokyo (JP)
(72) Inventor: Nakamura, Kunio c/o NEC Corporation, Minato-ku Tokyo (JP)
(74) Representative: Moir, Michael Christopher

(56) References cited:
- EP-A- 0 194 682
- EP-A- 0 223 616
- EP-A- 0 287 056

## Description

The present invention relates to a semiconductor memory, and more specifically to a semiconductor memory composed of single-transistor memory cells.

At present, semiconductor memories composed of single-transistor memory cells each consisting of one transistor and an associated capacitor for forming one information storing unit, have been the most widely utilized. In this type of semiconductor memories, if a transistor and an associated capacitor are formed in the same plane, the size of one memory cell becomes too large. Therefore, in order to miniaturize the memory cells so as to increase the density of the semiconductor memory, a so called stacked memory cell has been proposed and reduced into practice. In the stacked memory cell, an electric charge storage capacitor is formed by stacking two or more conducting layers in such a manner that an insulating film is sandwiched between each pair of adjacent conducting layers.

In order to further miniaturize the stacked memory cells, it has been ordinary practice to make the insulating layer of the stacked capacitor as thin as possible with the intention of preventing a capacitance decrease of the memory cell caused by a decrease in area of the capacitor. However, the thinning of the insulating layer of the stacked capacitor has resulted in an increase in pin holes and a decrease in the withstand voltage, and, therefore, a decrease in reliability.

A semiconductor memory device is known from EP-A-0194682. In this document, a device having a memory cell is produced by forming a cell partitioned by an insulating film for isolation between cells on the surface of a semiconductor substrate, providing a first electrode layer on the surface of the substrate through a first insulating film, providing a hole penetrating through the first electrode layer and the first insulating film, and providing a second electrode layer through a second insulating film in a manner to extend into the hole from the upward direction of the first electrode layer and connect with the substrate, thus forming a capacitor utilising the surface area of the substrate. The capacitance is further increased by the formation of a pn junction in the substrate below the first insulating film. This capacitor can also be formed by adding a groove type capacitor thereto. A charge transfer transistor can be provided in the memory cell.

A further semiconductor memory device is known from EP-A-0223616. The device comprises a semiconductor substrate of a first conductivity type, a field insulation layer on the semiconductor substrate, and a switch. This switch includes a gate insulation layer, a gate electrode on the gate insulation layer, and a pair of impurity regions of a second conductivity type in the substrate adjacent to the gate electrode. The device also includes a capacitor including a first electrode connected to one of the impurity regions, a second electrode connected to a predetermined voltage, insulation means for separating the first and second electrodes, and groove means extending into the substrate for increasing the capacitive area of the first electrode. A trench capacitor having a pn junction in the substrate surrounding the trench is described in EP-A-0 287 056.

It is an aim of the present invention to provide a semiconductor memory which can overcome the above mentioned defect of the conventional one.

Another aim of the present invention is to provide a semiconductor memory of the single-transistor type having a large cell capacitance in a restricted cell area.

A further aim of the present invention is to provide a semiconductor memory of the single-transistor type having a capacitance in addition to a stacked capacitor.

The above and other aims of the present invention can be achieved in accordance with the present invention by a semiconductor memory including at least one memory cell comprising an insulated gate field effect transistor and an associated stacked capacitor which are formed close to each other on a single substrate of a first conduction type, the insulated gate field effect transistor having a source and a drain which are located separately from each other in the single substrate and formed of impurity regions of a second conduction type opposite to the first conduction type, the insulated gate field effect transistor also having a gate formed through a gate insulator on a region between the source and the drain, the gate and the source of the insulated gate field effect transistor being connected to a word line and a bit line, respectively, the drain of the insulated gate field effect transistor being connected to one electrode of the stacked capacitor, the drain of the insulated gate field effect transistor including a low concentration region of the second conduction type positioned near to the gate of the insulated gate field effect transistor and a high concentration region of the second conduction type adjoining the low concentration region, the high concentration region of the drain being connected to said one electrode of the stacked capacitor, an impurity region of the first conduction type, having an impurity concentration higher than that of the substrate, being formed below the drain in the substrate to extend from the lower surface of the low concentration region over the lower surface of the high concentration region, so that a pn junction is formed between the impurity region of the first conduction type and the high concentration region, whereby the memory cell can have a cell capacitance of the sum of the capacitance of the stacked capacitor and the junction capacitance of the pn junction.

As seen from the above, the semiconductor memory in accordance with the present invention can provide, in addition to the stacked capacitor, a pn junction capacitor formed within the substrate by the impurity region of the first conduction type and impurity region of the second conduction type. Therefore, the memory cell of the semiconductor memory in accordance with the present invention can have a cell capacitance larger than the conventional stacked memory cell having the same chip area, without further thinning the insulating layer of the stacked capacitor, and, therefore, without decrease of the withstand voltage and the reliability. In another viewpoint, the memory cell of the semiconductor memory in accordance with the present invention can be formed with a chip area smaller than the conventional stacked memory cell having the same cell capacitance, without further thinning the insulating layer of the stacked capacitor, and, therefore, without decrease of the withstand voltage and the reliability.

In one preferred embodiment of the semiconductor memory in accordance with the present invention, a trench is formed into the substrate under the stacked capacitor. The impurity region of the first conduction type and the impurity region of the second conduction type are respectively formed to extend over a sidewall and a bottom of the trench, so that the pn junction between the two impurity regions extends over the sidewall and the bottom of the trench. With the arrangement, a large pn junction capacitance can be obtained. More preferably, the stacked capacitor enters or extends into the trench, so that the stacked capacitor itself can have an increased capacitance.

Preferred features of the invention are now described, by way of example only, with reference to the accompanying drawings, in which:
Figure 1 is a diagrammatic sectional view of an embodiment of the single-transistor memory cell in accordance with the present invention;
Figure 2 to 5 are diagrammatic sectional views illustrating some steps for manufacturing the single-transistor memory cell shown in Figure 1; and
Figures 6 to 8 are diagrammatic sectional views illustrating some steps for manufacturing a second embodiment of the single-transistor memory cell in accordance with the present invention.

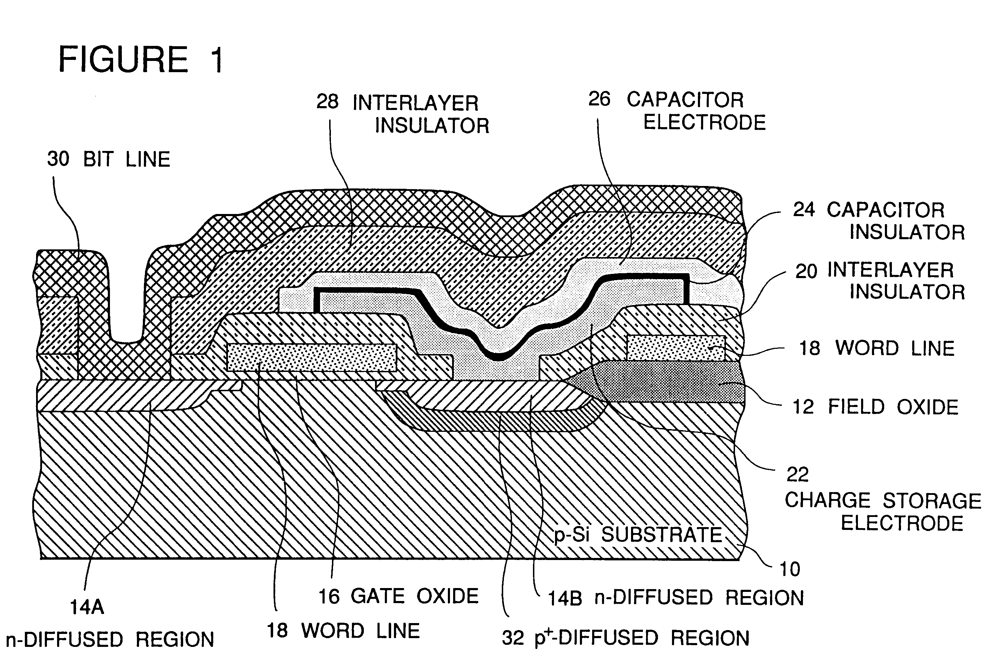

Referring to Figure 1, there is shown a diagrammatic sectional view of an embodiment of the single-transistor memory cell in accordance with the present invention. The shown single-transistor memory includes a p-type silicon substrate 10 having a field oxide 12 of about 0.5 µm formed on a principal surface thereof to surround and define individual device formation zones, respectively. In the device formation zone shown in Figure 1, n-diffused regions 14A and 14B are formed in the principal surface of the substrate 10, separately from each other. The n-diffused region 14A forms a source region and the n-diffused region 14B forms a drain region. On the principal surface of the substrate 10 between the n-diffused regions 14A and 14B, a gate oxide 16 is formed, and a word line 18 is formed on the gate oxide 16 and the field oxide 12. For example, this word line 18 is formed of a polycrystalline silicon having a thickness of about 0.3 µm, and extends in a direction perpendicular to the plane of the drawing. A portion of the word line 18 positioned between the n-diffused regions 14A and 14B acts as a gate electrode.

In addition, a low level interlayer insulator 20 is deposited to cover the word lines 18 and the surface of the substrate 10. A contact hole is formed through a portion of the interlayer insulator 20 above the n-diffused region 14B forming the drain region, and a charge storage electrode 22 is deposited in ohmic contact with the n-diffused region 14B through the contact hole and to extend on the interlayer insulator 20 so as to cover a half or more of the word lines 18. A capacitor insulator 24 is also deposited to completely cover the charge storage electrode 22, and a capacitor electrode 26 is formed to completely cover the capacitor insulator 24. Thus, a stacked capacitor composed of the charge storage electrode 22, the capacitor insulator 24 and the capacitor electrode 26 and connected to the n-diffused region 14B is formed above the n-diffused region 14B.

Furthermore, an upper level interlayer insulator 28 is deposited to cover the overall main principal surface of the substrate, and a contact hole is formed through a portion of the lower level and upper level interlayer insulators 20 and 28 above the n-diffused region 14A forming the source region. A bit line 30 is formed in ohmic contact with the n-diffused region 14A through the contact hole and to extend over the upper level interlayer insulator 28. This bit line 30 extends in a direction orthogonal to the word lines 18.

Thus, an insulated gate field effect transistor is formed of the n-diffused region 14A, the n-diffused region 14B and the word line 18 between the n-diffused region 14A and the n-diffused region 14B. This field effect transistor functions as a transfer gate between the bit line 30 and the stacked capacitor, namely, a switching element for charging and discharging the stacked capacitor from the bit line 30.

In addition, and in accordance with the present invention, a p⁺-diffused region 32 is formed to extend under the n-diffused region 14B forming the drain region, so that a pn junction capacitor is formed between the n-diffused region 14B and the p⁺-diffused region 32. This p⁺-diffused region 32 has an impurity concentration higher than that of the substrate 10. For example, the p⁺-diffused region 32 has 100 times or more the impurity concentration of the substrate 10. Since the n-diffused region 14B is connected to the charge storage electrode 22 of the stacked capacitor, this pn junction capacitor is in parallel to the stacked capacitor. Accordingly, the shown single-transistor memory cell has a cell capacitance which corresponds to the sum of the capacitance of the stacked capacitor and the capacitance of the pn junction capacitor.

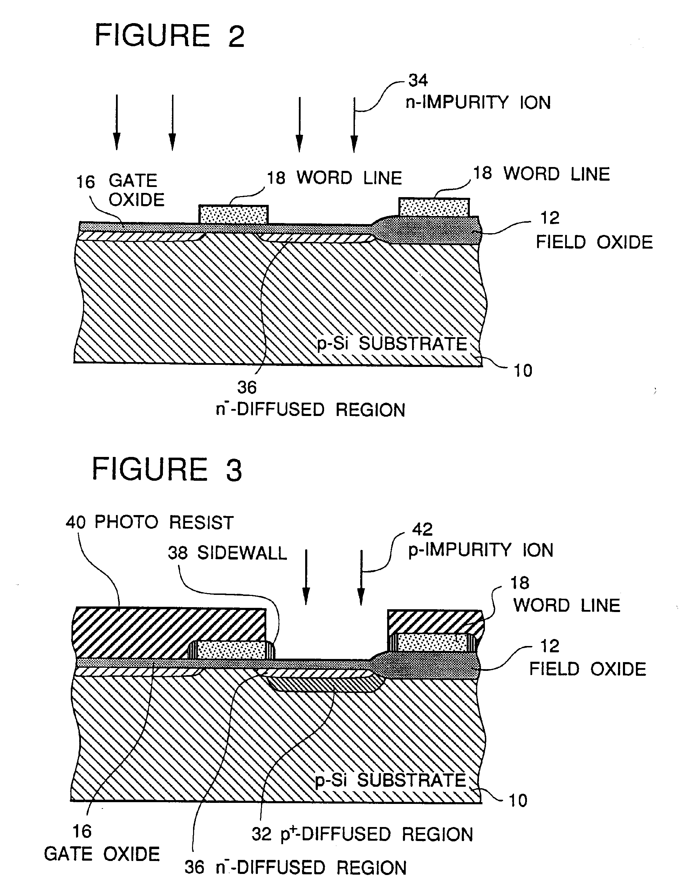

Now, explanation will be made of a process for manufacturing the above mentioned memory cell, with reference to Figures 2 to 5.

As shown in Figure 2, the field oxide 12 having a thickness of about 0.5 µm is formed on the main principal surface of the p-type silicon substrate 10 by means of an ordinary LOCOS (local oxidation of silicon) process. The gate oxide 16 of 100 to 200 Å thickness is formed to cover all the main principal surface of the p-type silicon substrate 10. Thereafter, a polycrystalline silicon layer of 2000 to 3000 Å thickness is deposited on the gate oxide 16, and patterned by a photolithography process so as to form the word line or gate electrode 18. By using the word line 18 and the field oxide 12 as a mask, n-type impurities 34 are ion-implanted so as to form an n-diffused region 36 for formation of an LDD (lightly doped drain) structure. For example, ³¹P⁺ (phosphorus) ions are implanted with a dose of 5 × 10¹² to 5 × 10¹³/cm² under an acceleration energy of 30 to 50 KeV.

As shown in Figure 3, a sidewall 38 is formed on each side of the word line or gate electrode 18. For example, this sidewall 38 is formed by forming an oxide layer of 1000 to 3000 Å thickness on a whole surface of the substrate 10, and etching back the formed oxide layer by a reactive ion etching, so that the oxide remains on only each side of the gate electrode 18.

Thereafter, a photoresist 40 is deposited and patterned to cover the surface of the substrate 10 excluding a future capacitor contact, and p-type impurities 42 are ion-implanted using the photoresist 40 as a mask, so as to form the p⁺-diffused region 32. For example, ¹¹B⁺ (boron) ions are implanted with a dose of 10¹² to 10¹³/cm² under an acceleration energy of 50 to 100 KeV.

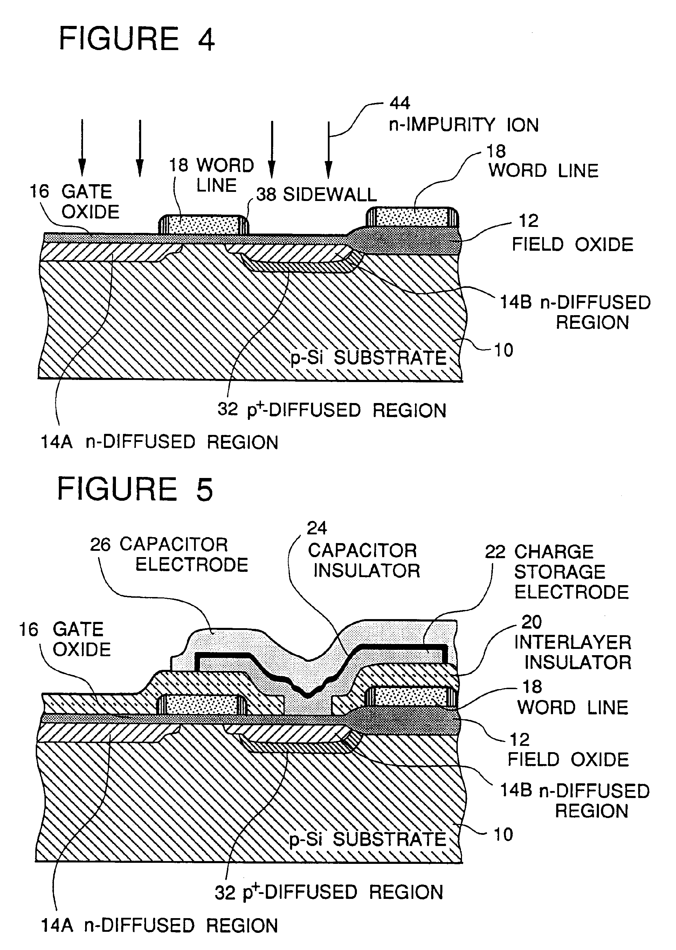

As shown in Figure 4, arsenic ions 44 are implanted so as to form the source diffused region 14A and the drain diffused region 14B. Thus, the LDD structure is formed by action of the sidewalls 38.

Thereafter, as shown in Figure 5, the interlayer insulator 20 is formed and patterned so that a capacitor contact hole is formed to expose a center portion of the drain diffused region 14B. A polycrystalline silicon layer of 2000 to 4000 Å is deposited and patterned by a photolithography process to form the charge storage electrode 22.

Then, the capacitor insulator 24 is formed. This capacitor insulator 24 is preferably formed of a double or triple layer structure composed of SiO₂ and Si₃N₄. An appropriate thickness of the capacitor insulator 24 is 50 to 100 Å in conversion of oxide layer.

Furthermore, a polycrystalline silicon layer of about 3000 Å is deposited and patterned by a photolithography process to form the capacitor electrode 26.

Thereafter, the upper level interlayer insulator 28 is deposited, and a contact hole is formed for the bit line 30. The bit line 30 is formed so as to complete the structure shown in Figure 1.

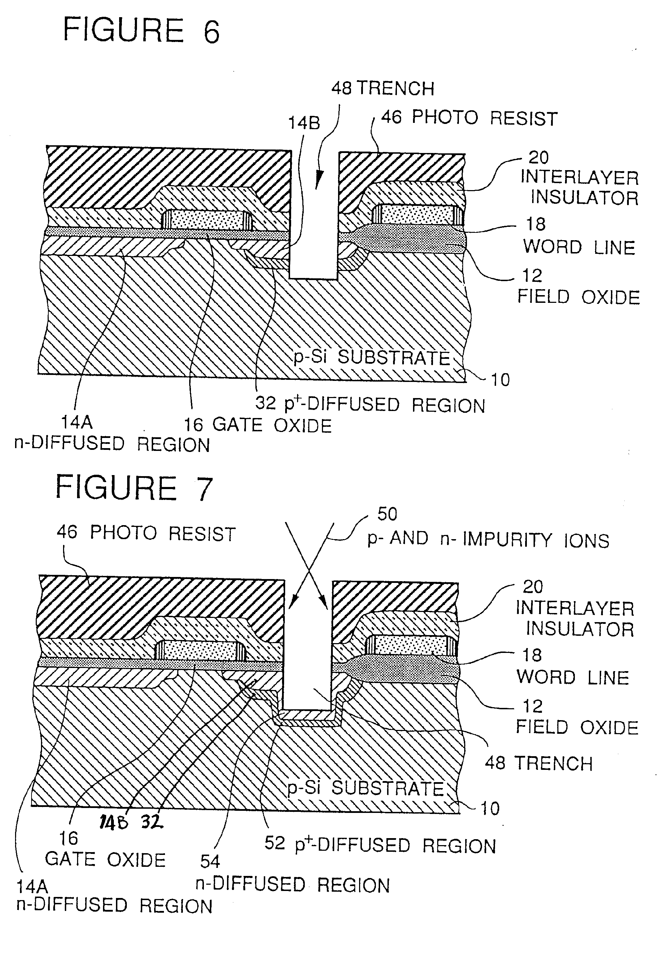

Referring to Figures 6 to 8, there are shown diagrammatic sectional views illustrating some steps for manufacturing a second embodiment of the single-transistor memory cell in accordance with the present invention.

Figure 6 shows a condition in which after the source diffused region 14A and the drain diffused region 14B are formed as shown in Figure 4, the lower level interlayer insulator 20 is formed and a patterned photoresist 46 having an aperture above the n-diffused region 14B is formed to cover the lower level interlayer insulator 20, and then the substrate is etched by using the photoresist 46 as a mask so that a trench 48 is formed to penetrate through the lower level interlayer insulator 20, the n-diffused region 14B and the p⁺-diffused region 32 into the p-type substrate 10.

Thereafter, as shown in Figure 7, p-type impurities and n-type impurities are sequentially ion-implanted to a side surface and a bottom surface of the trench 48, respectively. In order to implant ions to the side surface and the bottom surface of the trench 48, a so called "rotating inclined ion implantation" is used in which an ion beam is inclined to a wafer, and on the other hand, the wafer is rotated. The inclined angle of the ion beam to a direction perpendicular to the wafer is preferred to be 10° to 15°. By making the acceleration energy for the p-type impurities higher than that for the n-type impurities, a p⁺-diffused region 52 is formed to extend over the side surface and the bottom surface of the trench 48 and to adjoin with the substantially horizontally extending p⁺-diffused region 32, and an n-diffused region 54 having a depth shallower than the p⁺-diffused region 52 is formed to extend over the side surface and the bottom surface of the trench 48 and to adjoin with the substantially horizontally extending n-diffused region 14B. Thus, the pn junction capacitor formed between the p⁺-diffused regions 32 and 52 and the n-diffused regions 14B and 54 has a capacitance larger than that of the pn junction capacitor formed between the the substantially horizontally extending p⁺- and n- diffused regions 32 and 14B shown in Figure 1, by virtue of a pn junction formed on the side wall of the trench 48.

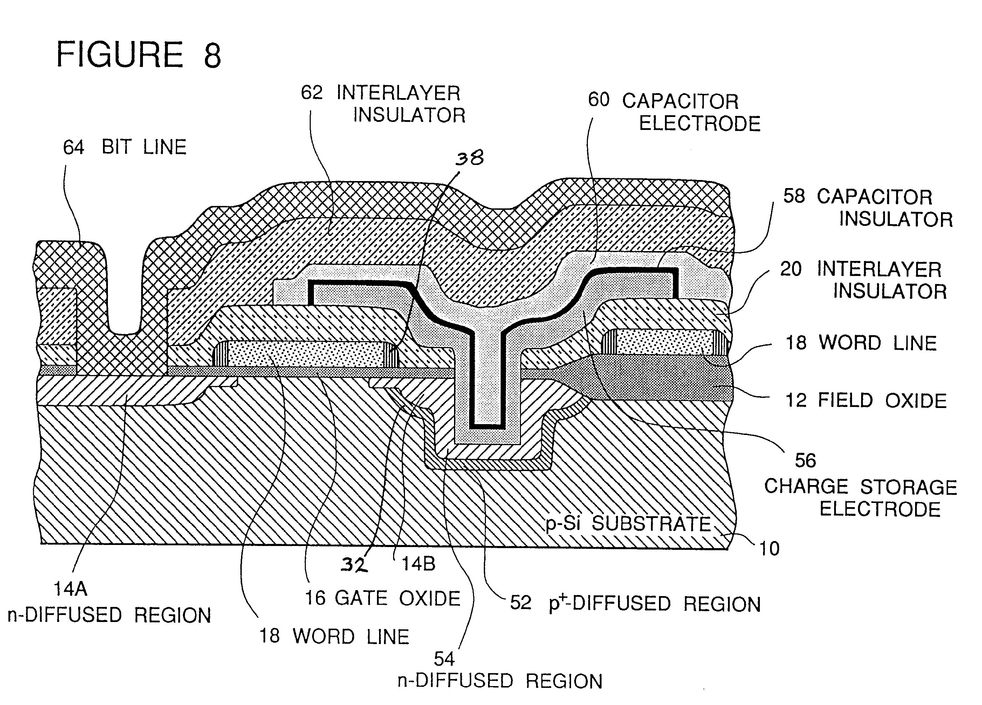

Thereafter, as seen from Figure 8, a charge storage electrode 56, a capacitor insulator 58, and a capacitor electrode 60 are sequentially formed. Then, an upper level interlayer insulator 62 is formed and a contact hole is formed at position corresponding to the n-diffused region 14A. A bit line 64 is formed on the upper level interlayer insulator 62 to contact the n-diffused region 14A through the contact hole formed in the lower level and upper level interlayer insulators 20 and 62.

As seen from Figure 8, a center portion of the stacked capacitor is folded to extend or enter into the trench 48. In other words, the stacked capacitor shown in Figure 8 has a capacitance larger than the stacked capacitor shown in Figure 1, by an amount corresponding to double the depth of the trench 48, namely an area of the side surface of the trench 48. Therefore, the structure shown in Figure 8 is very effective in minimizing the memory cell size.

The invention has thus been shown and described with reference to the specific embodiments. However, it should be noted that the present invention is in no way limited to the details of the illustrated structures but changes and modifications may be made within the scope of the appended claims.

## Claims

1. A semiconductor memory including at least one memory cell comprising an insulated gate field effect transistor (14A, 14B, 16 and 18) and an associated stacked capacitor (22, 24 and 26; 56, 58 and 60) which are formed close to each other on a single substrate (10) of a first conduction type, the insulated gate field effect transistor having a source (14A) and a drain (14B) which are located separately from each other in the single substrate and formed of impurity regions of a second conduction type opposite to the first conduction type, the insulated gate field effect transistor also having a gate (18) formed through a gate insulator (16) on a region between the source (14A) and the drain (14B), the gate (18) and the source (14A) of the insulated gate field effect transistor being connected to a word line (18) and a bit line (30), respectively, the drain (14B) of the insulated gate field effect transistor being connected to one electrode (22;56) of the stacked capacitor, the drain (14B) of the insulated gate field effect transistor including a low concentration region of the second conduction type positioned near to the gate (18) of the insulated gate field effect transistor and a high concentration region of the second conduction type adjoining the low concentration region (18), the high concentration region of the drain being connected to said one electrode (22;56) of the stacked capacitor, an impurity region (32;52) of the first conduction type, having an impurity concentration higher than that of the substrate (10), being formed below the drain (14B) in the substrate to extend from the lower surface of the low concentration region over the lower surface of the high concentration region, so that a pn junction is formed between the impurity region of the first conduction type (32;52) and the high concentration region, whereby the memory cell can have a cell capacitance of the sum of the capacitance of the stacked capacitor and the junction capacitance of the pn junction.

2. A semiconductor memory claimed in Claim 1 wherein a trench (48) is formed into the substrate under the stacked capacitor, and the impurity region (32;52) of the first conduction type and the high concentration region of the second conduction type are formed to extend over a sidewall and a bottom of the trench, so that the pn junction between the impurity region (32;52) of the first conduction type and the high concentration region extends over the sidewall and the bottom of the trench.

3. A semiconductor memory claimed in Claim 2 wherein the stacked capacitor extends into the trench, whereby the stacked capacitor itself can have an increased capacitance.

4. A semiconductor memory claimed in any of the preceding claims wherein the insulated gate field effect transistor further includes a first insulator film (38) formed at each side of the gate (18) and a second insulator film (20) formed to cover the gate (18) and the first insulator film (38), and wherein the impurity region (32;52) of the first conduction type is formed below a portion of the drain (14B) which is not covered by the gate (18), and the high concentration region of the drain is connected to said one electrode (22;56) of the stacked capacitor through an opening formed in the second insulator film (20).

## Patentansprüche

1. Halbleiterspeicher, der wenigstens eine Speicherzelle ein schließt, die einen Feldeffekttransistor (14A, 14B, 16 und 18) mit isoliertem Gatter und einen damit verknüpften gestapelten oder geschichteten (stacked) Kondensator (22, 24 und 26; 56, 58 und 60) aufweist, die nahe beieinander auf einem einzigen Substrat (10) eines ersten Leitungstyps gebildet sind, wobei der Feldeffekttransistor mit isoliertem Gatter eine Quelle (14A) und eine Senke (14B) aufweist, die getrennt voneinander auf dem einzigen Substrat angeordnet sind und aus Störstellenbereichen eines zweiten Leitungstyps gebildet sind, der dem ersten Leitungstyp entgegengesetzt ist, wobei die Feldeffekttransistoren mit isoliertem Gatter auch ein Gatter (18) aufweisen, das durch einen Gatter-Isolator (16) auf einem Bereich zwischen der Quelle (14A) und der Senke (14B) gebildet ist, wobei das Gatter (18) und die Quelle (14A) des Feldeffekttransistors mit isoliertem Gatter mit einer Wortleitung (18) bzw. einer Bitleitung (30) verbunden sind, wobei die Senke (14B) des Feldeffekttransistors mit isoliertem Gatter mit einer Elektrode (22;56) des gestapelten oder geschichteten Kondensators verbunden ist, wobei die Senke (14B) des Feldeffekttransistors mit isoliertem Gatter einen Bereich niedriger Konzentration des zweiten Leitungstyps, der nahe dem Gatter (18) des Feldeffekttransistors mit isoliertem Gatter angeordnet ist, und einen Bereich hoher Konzentration des zweiten Leitungstyps angrenzend an den Bereich (18) niedriger Konzentration aufweist, wobei der Bereich hoher Konzentration der Senke mit der einen Elektrode (22;56) des gestapelten oder geschichteten Kondensators verbunden ist, wobei ein Störstellenbereich (32;52) des ersten Leitungstyps mit einer Störstellenkonzentration, die höher ist als diejenige des Substrats (10), unterhalb der Senke (14B) im Substrat gebildet ist, um sich von der unteren Oberfläche des Bereiches niedriger Konzentration über die untere Oberfläche des Bereiches hoher Konzentration zu erstrecken, so daß ein pn-Übergang zwischen dem Störstellenbereich des ersten Leitungstyps (32;52) und dem Bereich hoher Konzentration gebildet ist, wodurch die Speicherzelle eine Zellenkapazität haben kann, die die Summe der Kapazität des gestapelten oder geschichteten Kondensators und der Übergangskapazität des pn-Übergangs ist.

2. Halbleiterspeicher nach Anspruch 1, bei der ein Graben (48) in das Substrat unter dem gestapelten oder geschichteten Kondensator eingeformt ist und der Störstellenbereich (32;52) vom ersten Leitungstyp und der Bereich hoher Konzentration des zweiten Leitungstyps so ausgebildet sind, so daß sie sich über eine Seitenwand und einen Boden des Grabens erstrecken, so daß der pn-Übergang zwischen dem Störstellenbereich (32;52) des ersten Leitungstyps und dem Bereich hoher Konzentration sich über die Seitenwand und den Boden des Grabens erstreckt.

3. Halbleiterspeicher nach Anspruch 2, bei dem der gestapelte oder geschichtete Kondensator sich in den Graben erstreckt, wodurch der gestapelte oder geschichtete Kondensator selbst eine vergrößerte Kapazität haben kann.

4. Halbleiterspeicher nach einem der vorangehenden Ansprüche, bei dem der Feldeffekttransistor mit isoliertem Gatter weiter eine erste Isolatorschicht (38), die auf jeder Seite des Gatters (18) ausgebildet ist, und eine zweite Isolatorschicht (20) aufweist, die so ausgebildet ist, daß sie das Gatter (18) und die erste Isolatorschicht (38) bedeckt, und wobei der Störstellenbereich (32;52) vom ersten Leitungstyp unterhalb eines Teils der Senke (14B) gebildet ist, der nicht durch das Gatter (18) bedeckt ist, und wobei der Bereich hoher Konzentration der Senke mit der einen Elektrode (22;56) des gestapelten oder geschichteten Kondensators durch eine Öffnung verbunden ist, die in der zweiten Isolatorschicht (20) ausgebildet ist.

## Revendications

1. Mémoire à semiconducteurs incluant au moins une cellule de mémoire comprenant un transistor à effet de champ à grille isolée (14A, 14B, 16 et 18) et un condensateur empilé associé (22, 24 et 26 ; 56, 58 et 60) qui sont formés près l'un de l'autre sur un unique substrat (10) d'un premier type de conduction, le transistor à effet de champ à grille isolée ayant une source (14A) et un drain (14B) qui sont situés séparément l'un de l'autre dans l'unique substrat et composés de régions d'impuretés d'un second type de conduction opposé au premier type de conduction, le transistor à effet de champ à grille isolée ayant aussi une grille (18) formée à travers un élément isolant de grille (16) sur une région entre la source (14A) et le drain (14B), la grille (18) et la source (14A) du transistor à effet de champ à grille isolée étant connectées à un fil de mot (18) et à un fil de bit (30), respectivement, le drain (14B) du transistor à effet de champ à grille isolée étant connecté à une électrode (22 ; 56) du condensateur empilé, le drain (14B) du transistor à effet de champ à grille isolée incluant une région à faible concentration du second type de conduction positionnée près de la grille (18) du transistor à effet de champ à grille isolée et une région à concentration élevée du second type de conduction adjacente à la région à faible concentration (18), la région à concentration élevée du drain étant connectée à ladite électrode (22 ; 56) du condensateur empilé, une région d'impuretés (32 ; 52) du premier type de conduction, ayant une concentration en impuretés supérieure à celle du substrat (10), étant formée au-dessous du drain (14B) dans le substrat pour qu'elle s'étende de la surface inférieure de la région à faible concentration jusqu'au-dessus de la surface inférieure de la région à concentration élevée, de telle sorte qu'une jonction pn est formée entre la région d'impuretés du premier type de conduction (32 ; 52) et la région à concentration élevée, la cellule de mémoire pouvant ainsi avoir une capacité de cellule égale à la somme de la capacité du condensateur empilé et de la capacité de jonction de la jonction pn.

2. Mémoire à semiconducteurs selon la revendication 1, dans laquelle une tranchée (48) est formée dans le substrat sous le condensateur empilé, et la région d'impuretés (32 ; 52) du premier type de conduction et la région à concentration élevée du second type de conduction sont formées pour qu'elles s'étendent au-dessus d'une paroi latérale et d'un fond de la tranchée, de telle sorte que la jonction pn entre la région d'impuretés (32 ; 52) du premier type de conduction et la région à concentration élevée s'étend au-dessus de la paroi latérale et du fond de la tranchée.

3. Mémoire à semiconducteurs selon la revendication 2, dans laquelle le condensateur empilé s'étend jusque dans la tranchée, le condensateur empilé proprement dit pouvant ainsi avoir une capacité accrue.

4. Mémoire à semiconducteurs selon l'une quelconque des revendications précédentes, dans laquelle le transistor à effet de champ à grille isolée comprend en outre un premier film isolant (38) formé de chaque côté de la grille (18) et un second film isolant (20) formé pour qu'il recouvre la grille (18) et le premier film isolant (38), et dans laquelle la région d'impuretés (32 ; 52) du premier type de conduction est formée au-dessous d'une partie du drain (14B) qui n'est pas recouverte par la grille (18), et la région à concentration élevée du drain est connectée à ladite électrode (22 ; 56) du condensateur empilé par un trou formé dans le second film isolant (20).
